# EUROPEAN PATENT APPLICATION

(11) **EP 0 871 049 A1**
(43) Date of publication of application: **14.10.1998**
(21) Application number: 97302500.0
(22) Date of filing: 11.04.1997
(51) Int. Cl.: G02B 6/42, H01S 3/025, H01L 31/0232, H01L 33/00

(54) **Semiconductor device**

(71) Applicant: Hewlett-Packard Company, Palo Alto, California 94304 (US)
(72) Inventor: Charles, Paul Marshall, Bramford, Suffolk IP8 4AD (GB); Owen, Martyn, Wattisfield, Diss, Norfolk IP22 1LF (GB); Beaumont, Howard Charles, Ipswich,Suffolk IP2 8PH (GB)
(74) Representative: Lawrence, Richard Anthony

(57) **Abstract**

A semiconductor device in the form of a prism is described. The device has a top face 2, and two side faces 3, 4. The two side faces 3, 4 each make with the top face 2 a substantially equal acute angle in the device, and the parts of the device defining the two side faces comprise semiconductor material. Such a device is especially suitable for location in a v-groove on a semiconductor substrate. If the device and the substrate have the same crystal structure, then the device angle and the v-groove angle can be matched by selecting the same crystal plane in each material. This technique can thus be used for InP semiconductor lasers located within silicon v-grooves. Optical fibres can be passively aligned with such semiconductor devices in v-grooves. Methods of fabricating such semiconductor devices are discussed.

## Description

The present invention relates to a semiconductor device, and is particularly relevant to a semiconductor device adapted for use with a grooved substrate.

A known advantageous technique in the manufacture of fibreoptic components is the use of a silicon substrate containing a groove for location of fibres. Such an "optical bench" of silicon allows for passive alignment of optical fibres with optical components - this is particularly significant in alignment of semiconductor lasers to singlemode fibre. Such an arrangement is shown in "Passive alignment of a tapered laser with more than 50% coupling efficiency", J.V. Collins et al, Electronics Letters, Vol. 31, No. 9, pp. 730-731, 1995. This arrangement requires accurate placement of a precision-cleaved laser to achieve the required degree of coupling. Silica stops are constructed on the substrate to assist in this accurate placement, and the patterning of the substrate is thus relatively complex.

An approach to growth of InP lasers suitable for use in such optical bench structures is taught in "Hybrid Integration of Semiconductor Lasers with Si-based Single-Mode Ridge Waveguides", Etienne E.L. Friedrich et al, Journal of Lightwave Technology, Vol. 10, No. 3, 336-339, 1992. In this arrangement, the InGaAsP active stripe of the laser is aligned between a pair of wide stripes. Each wide stripe is separated from an adjacent wide stripe of an adjacent layer by a V-groove using (111) crystalline planes. Lasers cleave readily at these V-grooves, the resulting lasers thus being accurately dimensioned with the active stripes of the laser being accurately positioned with respect to the dimensions of the laser itself.

A further example of such an optical bench structure, but in which the grooved substrate is of InP, rather than silicon, is given in "Monolithically Integrated Laser/Rear-Facet Monitor Arrays with V-Groove for Passive Optical Fiber Alignment", Mark A. Rothman et al, IEEE Photonics Technology Letters, Vol. 5, No. 2, pp. 169-171, 1993. In this structure, a laser and rear-facet monitor are grown directly on to the InP substrate, and a V-groove is etched for location of the fibre by wet chemical etching with HCl and acetic acid revealing the (112) crystal plane. In this process, the alignment of the groove with the grown laser and rear-facet monitor is critical. There are also a large number of steps in the fabrication process for the integrated laser/rear-facet monitor/grooved substrate.

Such prior art arrangements require precise construction of the substrate, or optimised mounting of an optical component on the substrate, to achieve the high degree of coupling required. An approach which is not so dependent on accurate manufacture of the substrate or of accurate fibre or component placement on it is shown in German Patent Publication DE 33 07 669 C 2. This arrangement employs a silicon substrate with a V-groove for passive location of optical fibres. However, the laser is mounted on a V-shaped carrier. This allows passive location of both laser and optical fibres in the V-groove of the substrate. For accurate location, this design requires accurate conformation of the carrier shape with that of the V-groove in the substrate, together with precise mounting of the laser on the carrier itself.

It is desired to produce semiconductor devices more suitable for assembly in fibre optic components than in the prior art. In particular, it is desired to produce semiconductor devices capable of passive alignment with optical fibres without any need for a precision alignment of device and V-groove.

Accordingly, the invention provides a semiconductor device in the form of a prism having a top face and two side faces, wherein each side face makes with the top face a substantially equal acute angle in the device, wherein the parts of the device defining the two side faces comprise semiconductor material.

Such a semiconductor device is particularly advantageous, as it can be passively aligned within a V-groove in a semiconductor substrate in the same manner as an optical fibre. Accordingly, the invention further provides a semiconductor component comprising a semiconductor substrate having a V-shaped groove therein and one or more semiconductor devices as indicated above located in the V-shaped groove, wherein the angle of the V-shaped groove is matched to the angle between the two side faces of the semiconductor device. In preferred optical component embodiments, the groove also contains optical waveguide, preferably optical fibres, optionally single mode fibres.

In embodiments, the semiconductor device comprises an optical waveguide. In embodiments the optical waveguide is a semiconductor laser, and in preferred cases a buried heterostructure laser. In alternative embodiments other designs of semiconductor laser could be employed, such as a distributed feedback laser - alternatively, the waveguide is comprised within a different device functionality, for example a photodetector. In embodirnents of the device the edges between the side faces and the top face of the substrate is defined by pinning edges, which in embodiments are edges of edge mesas. The positioning of the active region of the semiconductor laser in semiconductor laser embodiments relative to the edge mesas thus will determine the location of the laser active region with respect to the V-groove of a substrate in which it is placed.

In a further aspect, the invention provides a method of manufacturing a semiconductor device, comprising: depositing two edge mesas on a semiconductor device;manufacturing a semiconductor device functionality between the two edge mesas; etching back around the device functionality to reveal at least a part of each edge mesa; etching the substrate using the edge mesas as masks to form angled side surfaces, the side surfaces each being disposed such as to make an acute angle within the substrate to a top surface of the substrate.

Advantageously, the method further comprises the step of thinning the substrate: this may take place before or after etching the substrate to form the side surfaces.

In particularly preferred embodiments an active region for the semiconductor device is formed in the same step as the formation of the edge mesa regions: this allows the device functionality to be located accurately with respect to the edges of the device. Application of the invention is particularly appropriate where the semiconductor device functionality is a semiconductor laser functionality.

Specific embodiments of the invention are described below, by way of example, with reference to the accompanying drawings, in which:
Figure 1 shows a semiconductor device according to an embodiment of the invention in a cross-section normal to the length of the device;
Figure 2 shows a semiconductor component incorporating a semiconductor substrate with a V-groove, and a semiconductor device as shown in Figure 1 and an optical fibre passively aligned in the V-groove;
Figures 3a to 3j show steps in a method of fabrication of a semiconductor device in accordance with an embodiment of the invention.
Figures 4a to 4c show the progress of an etch for defining the sidewalls of the device.

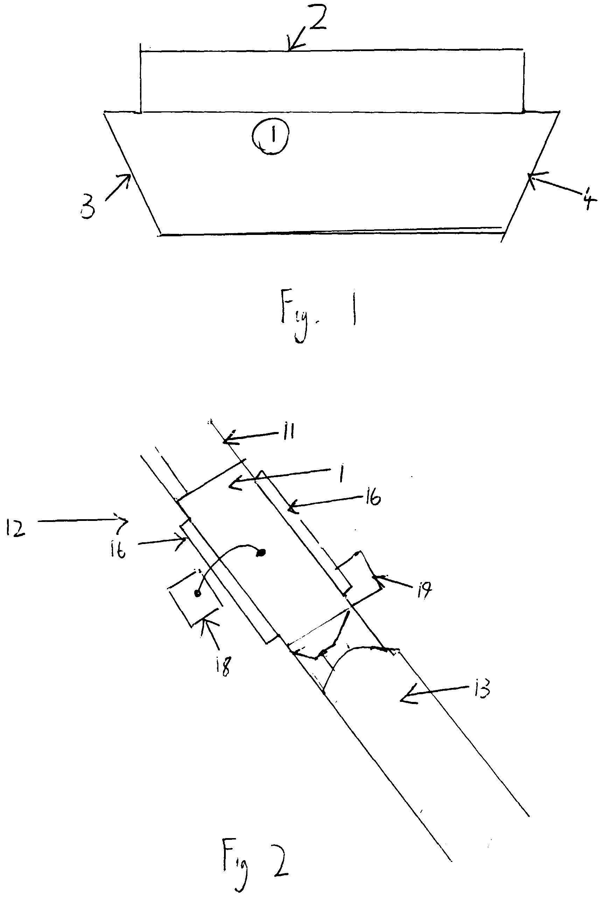

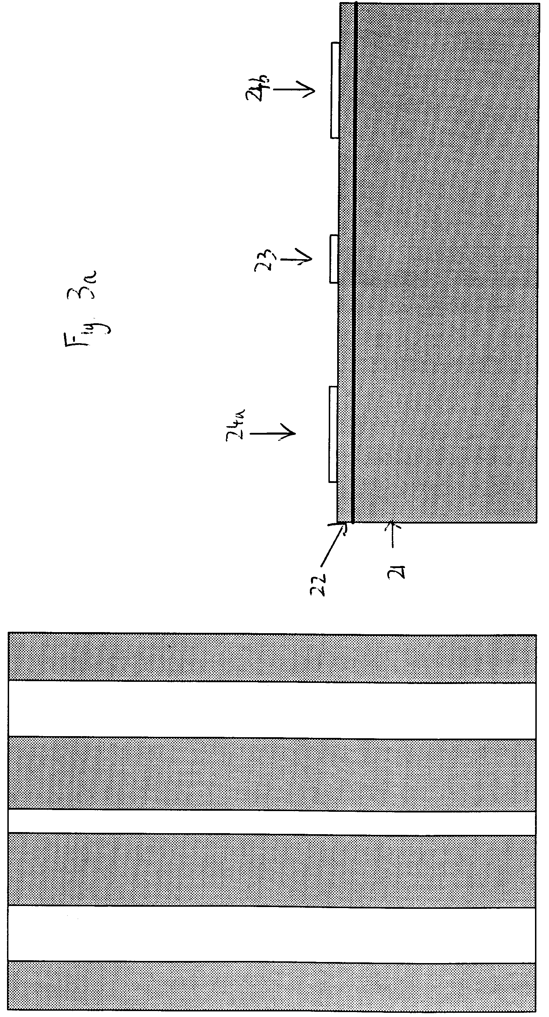

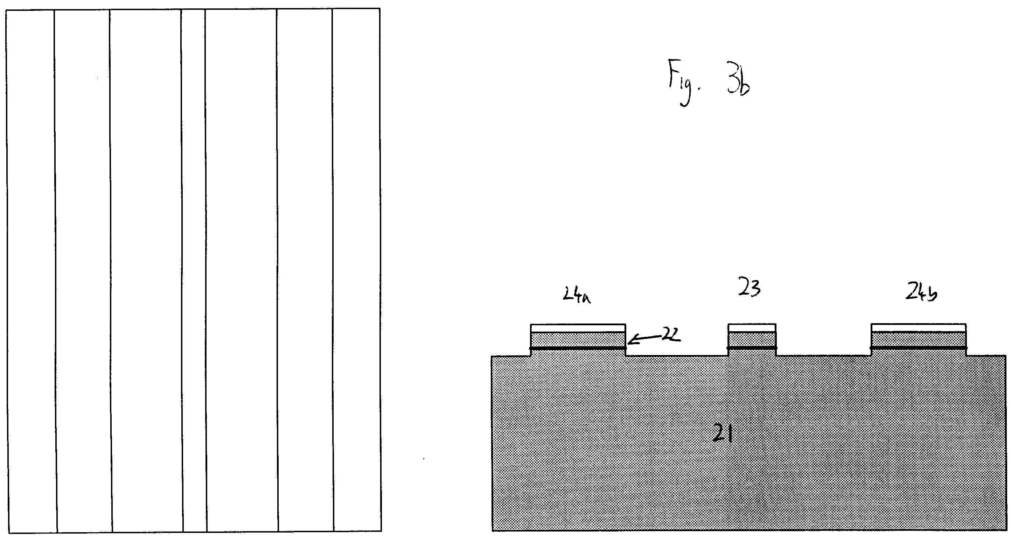

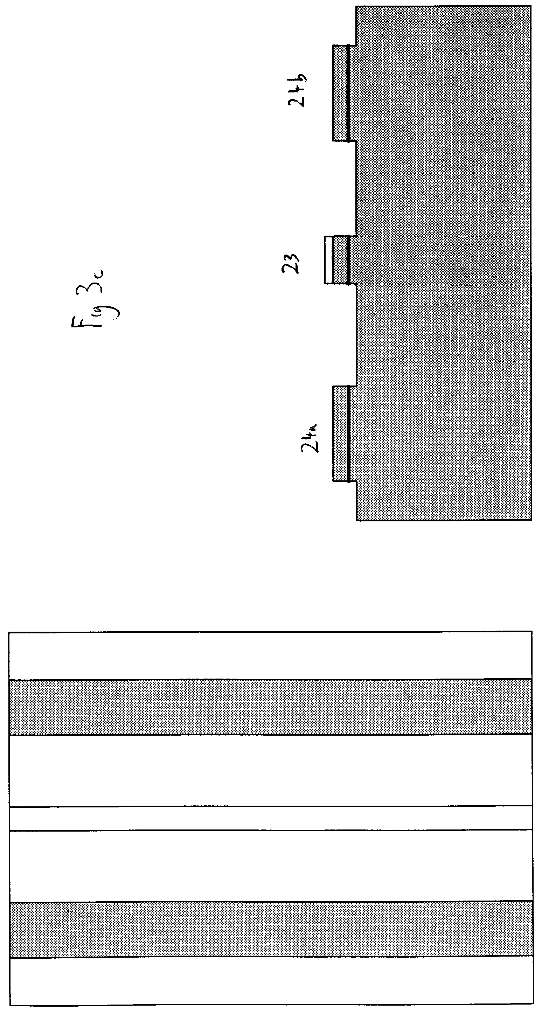

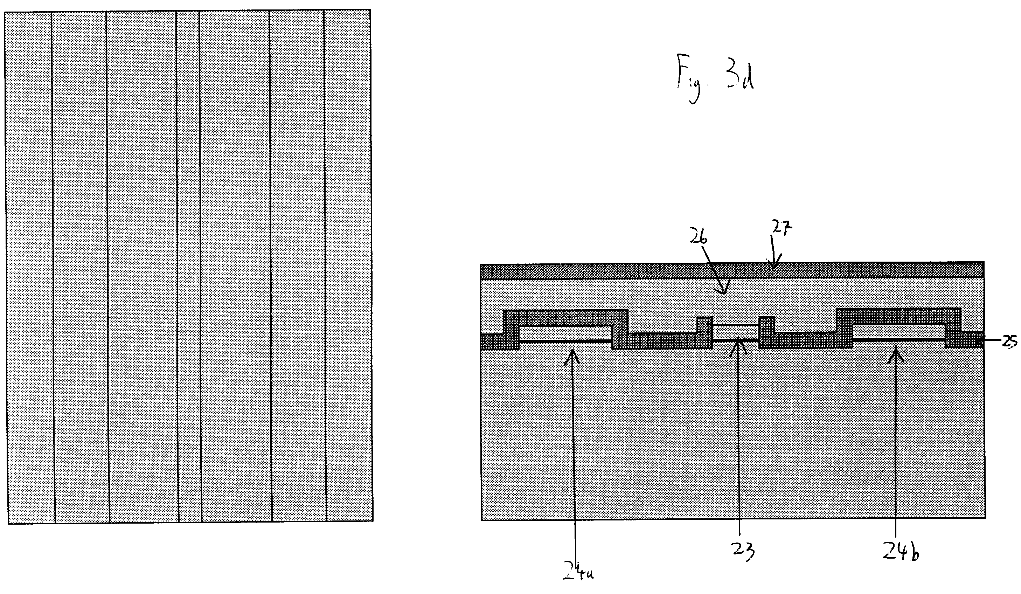

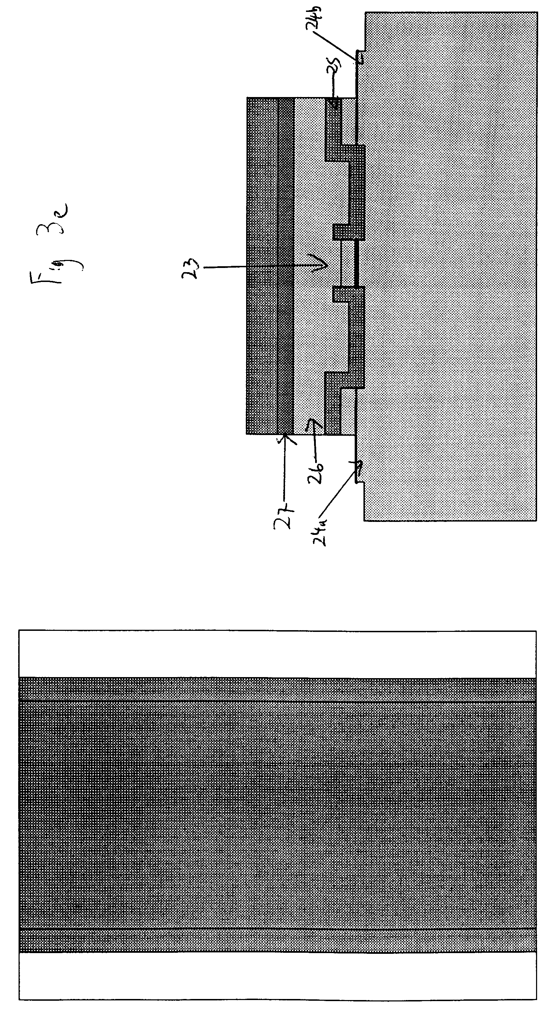

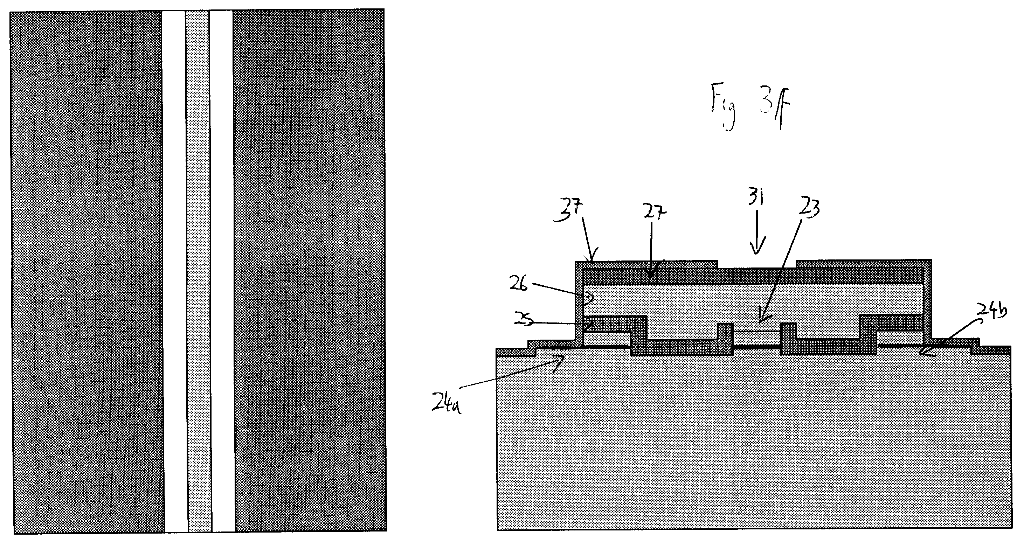

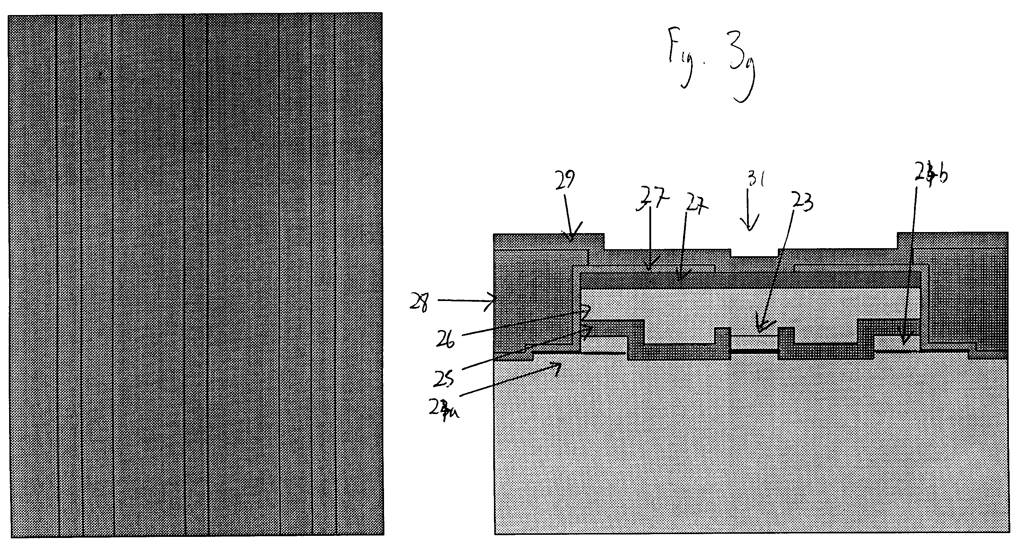

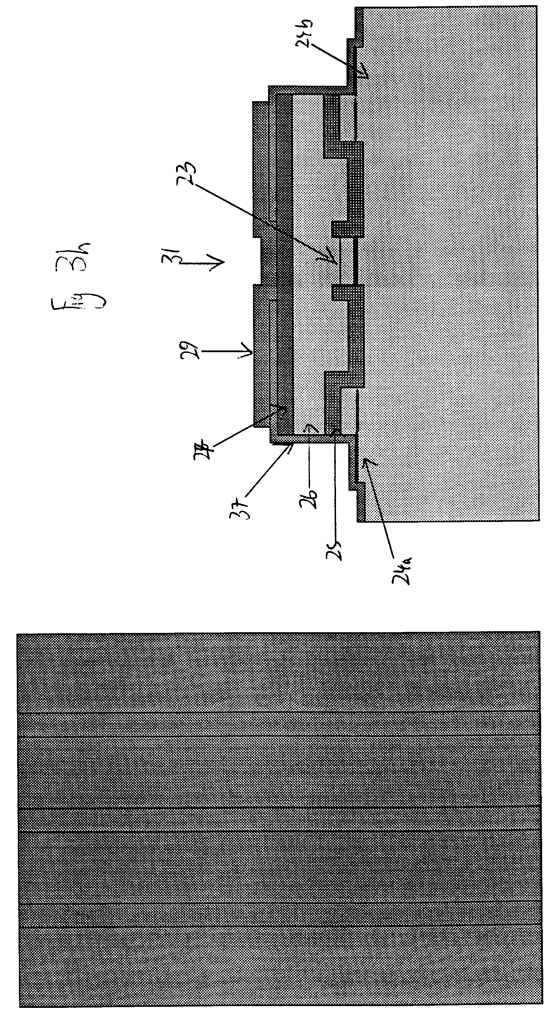

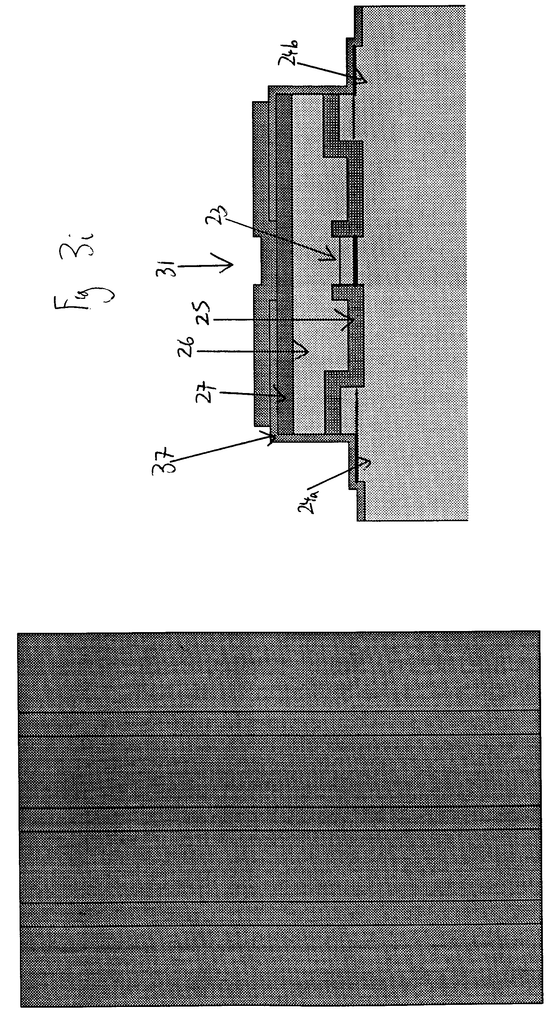

Figure 1 shows a semiconductor device 1, in this case a semiconductor laser diode, in the shape of a prism. It has a top face 2 and two side faces 3,4. The side faces are disposed at an equal acute angles to the top face. These angles are defined in the semiconductor substrate of the device, which in this embodiment is InP. The angles are defined by the [111] family of crystal planes of InP, the top face of the substrate being defined by the (100) plane. The prism is truncated by a lower face, so that the section of the device normal to its length is substantially trapezoidal.

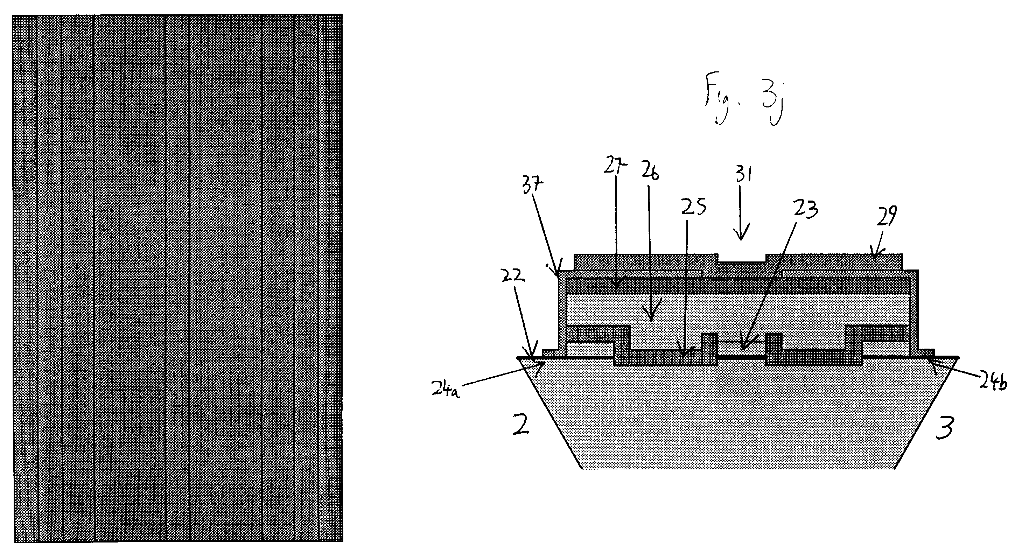

This structure is particularly advantageous, as it allows passive alignment of a semiconductor device with an optical fibre in a silicon optical bench without any need for precision positioning of the device. This is shown in Figure 2. The semiconductor device 1 is positioned in a V-groove 11 in a silicon substrate 12 acting as an "optical bench". Automatically aligned with the semiconductor laser is an optical fibre 13, which may be a single mode optical fibre. Centring of the active region of the laser diode with the optical fibre is achieved automatically on location in the V-groove. Vertical alignment of the device with respect to the substrate is also controlled by control of the dimensions of the semiconductor device and the V-groove. However, it is the matching of device dimensions to optical fibre dimensions that is critical to practical vertical alignment, as the device-to-fibre alignment is relatively tolerant of V-groove width - if the V-groove is narrower than specified, for example, the result is that both the semiconductor device and the optical fibre will be vertically displaced by a similar degree as a result.

Effective location of the semiconductor device 1 within the V-groove 11 is achieved because of the match of the angle of the V-groove 11 to that of the side face angles of the semiconductor device 1. This match is readily achievable if both optical bench substrate and device substrate are of the same semiconductor material and the same crystal planes are revealed. However, this match is also achievable if the optical bench substrate semiconductor and the device substrate semiconductor share the same crystal structure. In the embodiment shown, the optical bench substrate semiconductor is silicon, whereas the device substrate semiconductor is InP. Both silicon and InP have a face-centred cubic (fcc) crystal structure, and thus the same sets of crystal plane angles apply. In particular, both Si and InP have an angle of 54.7°.

While matching of the angles of the V-groove 11 and the side faces of the semiconductor device 11 allows reproducible location of the device with respect to the groove, a potential difficulty does arise from the extended area of contact between the V-groove 11 and the side faces 3,4 of the device. This is that the presence of an irregularity or foreign body anywhere along the area of contact will cause a positioning error. This is remedied by reduction in the area of contact, as is shown in Figure 2. As can be seen, the V-shaped groove 11 has an increased width region 16 of shorter length than the semiconductor device 1. The semiconductor device 1 is then located to span the whole length of the increased width region. There is thus no contact between the semiconductor device 1 and the V-groove 11 along the increased width region. The mounting surfaces of the V-groove 11 which do contact the side faces 3,4 of the semiconductor device 1 are substantially smaller than the equivalent surfaces of the increased width region 16, and the risk of a positioning error is reduced accordingly.

As can also be noted from Figure 2, the positioning of a semiconductor device within a V-groove, rather than proud of the optical bench substrate surface, has advantages in construction of a component. Necessary electrical contacts (here p-contact 18 and n-contact 19) can be formed adjacent to the device and on substantially the same vertical level - this allows contacts and device to be joined by very short wires, maximising efficiency and speed both in manufacture and in performance.

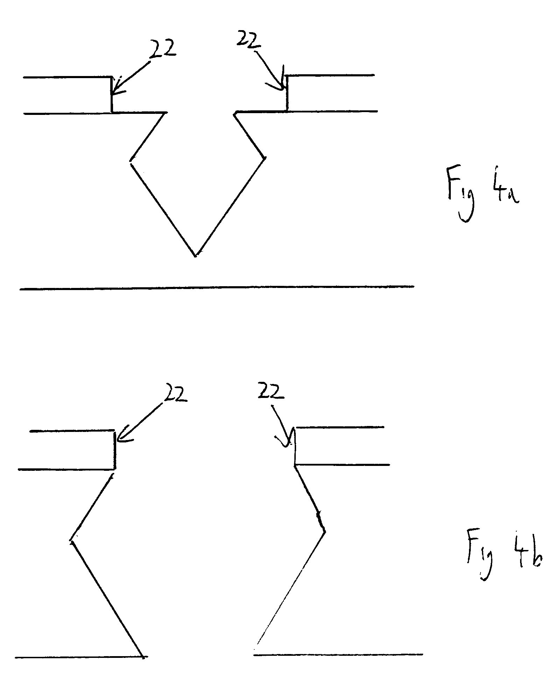

The Si V-groove can be formed by conventional means well known to the man skilled in the art, such as wet etching with potassium or caesium hydroxide. The formation of the prism-shaped semiconductor device 1 is less straightforward - an embodiment of a method for fabricating such a device is set out below with reference to Figure 3a to 3j.

The initial step is to grow an active layer 22 on to an InP substrate 21. This active layer 22 can be fabricated according to known techniques for fabricating planar active lasers for a diode laser - the active layer could be a bulk region or a strained multiple quantum well (SMQW) structure. An appropriate structure of SMQW device is discussed in W.S. Ring et al, Optical Fibre Conference, Vol. 2, 1996 Technical Digest Series, Optical Society of America. The type of active layer employed is not critical to the invention.

Figure 3a shows the following step, of deposition of an SiO₂ layer followed by patterning to form three mesa regions 23, 24a and 24b. Patterning is achieved by standard photolithographic processes, for example through the spinning, exposure and development of a photoresist layer, which is then etched. Mesa region 23 is to form the active region of the resulting semiconductor device. Edge mesa regions 24a and 24b do not have significance in the function of the device when completed. However, these regions do have a significant role in the fabrication of the device. Edge mesa regions 24a, 24b determine the edge position of the completed device, so their separation determines the height at which the completed device will sit in any specific silicon V-groove, and the central position of the laser with respect to the device (and hence the V-groove) is determined by the positioning of mesa region 23 with respect to edge mesa regions 23a and 24a. It is therefore highly desirable for good device formation to etch the edge mesas and the active region mesa in the same step, so that the position of the laser within the device, and hence with regard to the V-groove in which it will sit, is accurately defined. It should be noted that silicon nitride, for example, would be a suitable alternative choice to SiO₂ for defining the mesa regions.

In this fabrication, the edge mesas 24a, 24b are of the same material as active mesa 23 - in the preferred case of a SMQW structure, this will be a quaternary structure (GaAsInP). It is not necessary for the edge mesas to be of such a material. For satisfactory function, the edge mesas must be securely adhered to the underlying structure (e.g. through formation as a well-adhered epitaxial layer), and resistant to the sidewall-forming etch and capable of pinning the etched sidewall so that the sidewall forms controllably. The basic requirement for formation of the desired device shape is to have pinning edges which act to pin the etch of the substrate material. The edges are in this case the outer edges of the edge mesas - however, alternative steps can be taken to form an edge with a layer of material which is not etched by the etch to form the sidewalls and which also pins the sidewalls, preventing undercutting so that the desired crystal plane is revealed in a manner so as substantially to contain the pinning edge within the plane of the sidewall.

The next step, as shown in Figure 3b, is to etch back around the mesas to remove the active region outside the mesa regions. This is a conventional step in the fabrication of buried heterostructure lasers, and appropriate techniques such as wet etching (with Br/HBr) or Reactive Ion Etching (RIE) can be employed. An appropriate wet etch has the composition 14:1:9 H₂O:(Br/HBr - 1:17):HBr. This step needs to be carried out accurately, as irregularities in the formation of the outer edge of the edge mesas 24a, 24b directly affect the dimensions of the finished prism-shaped device. It is therefore particularly important in this etch to ensure that there is minimal undercutting of the edge mesas 24a, 24b at the outer, sidewall-defining, edges. The amount of undercut that is acceptable will be dependent on the dimensions of the final filled workbench structure and of the active parts of the devices in the structure - a small undercut (in the region of 1 to 1.5 *µ*m) will generally be acceptable for practical purposes.

The next step, as shown in Figure 3c, is to strip away the SiO₂ layer from the edge mesa regions 24a, 24b. This step, which can be carried out with hydrofluoric acid, is necessary to prevent the formation of lasing mesas in the edge mesa regions 24a, 24b.

The series of following steps illustrated together in Figure 3d are essentially conventional steps in the fabrication of a buried heterostructure semiconductor diode laser. Blocking layer 25 is first grown onto the device by an appropriate technique (such as selective area atmospheric pressure MOVPE). Overgrown blocking layer 25 comprises two layers, the lower layer being a p-doped InP layer of 0.5 *µ*m and the upper layer an n-doped InP layer of 0.5 *µ*m. Removal of SiO₂ in the edge mesa regions 24a, 24b enables the overgrowth to take place smoothly over these regions without perturbation of the overgrowth process. No overgrowth takes place over the laser mesa region 23, which is capped by SiO₂ - SiO₂ acts as a growth barrier to InP. After this, the SiO₂ cap is removed from laser mesa region 23 with hydrofluoric acid and capping layers 26, 27 are grown over the structure by atmospheric pressure MOVPE. Layer 26 is p-doped InP and layer 27 consists of p-doped InGaAs. After these steps, the basic buried heterostructure of a buried heterostructure semiconductor laser has been completed.

The following step, shown in Figure 3e, is significant in the forming of the prismatic shape. The top, ternary, layer 27 is patterned (using conventional photolithography as before) and then etched with a sulphuric acid and hydrogen peroxide etch. The etched ternary layer is then used as a mask for the etching of the InP layers with an aqueous HBr solution - this approach is effective to ensure that there will not be significant undercutting. This step will etch through all layers up until the active regions 22 in the edge mesa regions 24a, 24b - however, the etch will not affect these active regions. It is thus a key part of the process that the combination of etch for this stage and material for the edge mesa regions 24a, 24b is such that the edge mesa regions are substantially unetched. It is necessary in this stage to reveal at least the outer edges of edge mesa regions 24a, 24b that are later to define the sidewalls of the prismatic device.

After this, the necessary steps are followed to complete the buried heterostructure semiconductor laser functionality. Firstly, as shown in Figure 3f, a dielectric passivation layer 37 (of, for example, SiO₂) is deposited and patterned and etched (with 10:1 buffered HF) to reveal a contact hole 31. This passivation layer 37 also has the secondary purpose of protecting the sidewalls of the edge mesa regions 24a, 24b during the remainder of the laser functionality formation steps. The following stage, shown in Figure 3g, involves the formation of the first part of a metal contact with Ti/Pt as contact metal. The metal contact is formed in two stages, the first stage containing Pt and the second Au. Before deposition of this metal layer, however, a photoresist 28 is defined to either side of the central region of the device (as is shown in Figure 3g) to planarise the device. After deposition of the metal layer 29, typically by E beam, a liftoff process follows (see Figure 3h) to remove the photoresist and also the part of the metal layer 29 attached to the photoresist 28. Such a liftoff procedure is required as the Ti/Pt layer cannot be satisfactorily removed by wet etching. The Ti/Pt metallisation is thus removed by liftoff from the regions in which etching of the substrate to form the prismatic device will occur.

Following this step, the metal contact is completed by deposition of a Ti/Au layer, typically by sputtering, and patterning (not shown) to complete the device functionality. The Au layer is wet etched (e.g. 50:29:56 H₂O:I:KI) and Ti etched with HF, leaving the structure shown in Figure 3h.

The next required step, shown in Figure 3i, is to thin the device substrate to the final intended thickness. The thickness to be achieved is not critical, as it does not itself determine at what level within the V-groove the device will sit, but it is necessary for the substrate thickness to be less than the depth of the V-groove into which it is to fit. An appropriate thickness to achieve is one which would leave approximately 5-10 *µ*m clear space at the bottom of the V-groove, which with conventional silicon optical bench design would leave a device thickness in the range of 70-80 *µ*m. Such thinning may be achieved by a combination of mechanical and chemical means. Firstly the device is bonded to a block, and then ground on a rotating wheel to thin it from an initial 300 *µ*m to approximately 100 *µ*m. The remaining thinning is achieved through polishing of the wafer. The details of this process, and of alternative processes that will be equally satisfactory in effect, will readily be understood by those skilled in the art.

The final step, shown in Figure 3j, is the creation of the V-trenches needed to provide the desired prismatic shape to the device. Firstly, it is necessary to protect the n-side (consistently depicted as the lower surface in Figure 3) of the semiconductor wafer from etching. This may be achieved by depositing a dielectric film on the n-side of the substrate, or else by mounting the substrate on a carrier. A particularly effective approach is to mount the device substrate on to an appropriate mechanical support (e.g. a silicon wafer) with a low temperature wax, such as Logitech PD8085 wax. It is then necessary, if the step has not already been taken, to break out the dielectric film 37 in the trench region to allow the etch to take place.

At some stage before the final V-trench etch, a rapid non-specific etch (for example,with a non-specific HBr solution) may be made to clean surfaces.

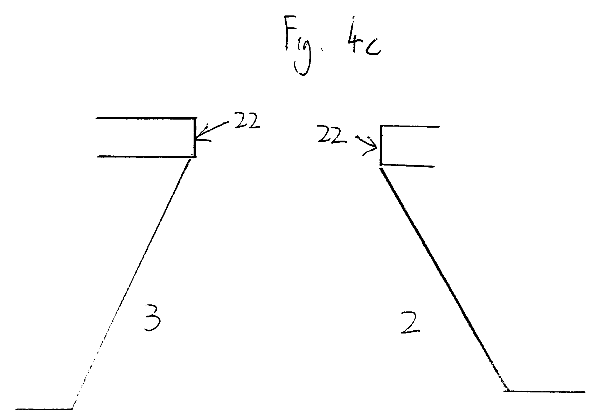

The etch is conducted, for an InP substrate, with aqueous HBr. The process of the etch is shown in Figure 4. It is found that a concentration of 48% HBr results in etching along a [111] crystal plane (Figure 4a): preferred etch temperature is 20_{°}C. The role of the active region in edge mesa regions 24a, 24b is crucial to the process: the active region is not etched by this HBr solution, and so the outside pinning edge of the edge mesas acts to pin the relevant [111] plane against further etching (Figure 4b). Accordingly, the extent of the active region defines the relevant edge of the semiconductor device and mask undercutting does not occur. The two side faces of the device are formed controllably in the intended positions. For formation of a satisfactory device shape, it is found to be desirable to allow the etch to continue until the support wax is revealed, and then to continue the etch until the desired prismatic shape is formed (Fig. 4c): with the etch and device thickness discussed here, a period of approximately 5 minutes is satisfactory.

Once the V-trenches have been etched, the device needs to be accurately dimensioned - the device substrate at this point will contain a number of elongated bar-shaped devices. These bars are typically several times the desired length of a laser, and it will now generally be necessary to form a number of lasers from one of these bars. One possible solution is to etch these bars with a suitable etchant to form a series of trenches at right angles to the length of a device bar. A preferred, effective, technique is to use "skip-scribing", in which an appropriate scribing tool is translated across the device surface at right angles to the length of a device bar. The bars can then removed from the silicon substrate, placed on a tacky film, and broken into individual lasers through conventional means at the scribed points.

The resulting diode laser with its prismatic form is particularly well adapted for use in a fibreoptic component based around a silicon optical bench. The laser can be located in the silicon V-groove, where it will readily align with an optical fibre placed in the V-groove. Moreover, as with appropriate construction the upper p-side of the laser can be adapted to lie substantially level with the upper face of the silicon optical bench, only short wires are required between the laser contacts and substrate contacts. Such a p-side upward arrangement allows for particularly advantageous component construction.

Although the example discussed here is that of a semiconductor diode laser, it will readily be appreciated by the man skilled in the art that other devices could be constructed in the desired prismatic shape by using appropriate steps of those indicated above to modify the conventional fabrication route for such devices. For example, an edge detector could be formed as a prismatic device and could be located adjacent to a prismatic semiconductor laser in a silicon V-groove.

Devices according to the present invention can thus be used for fabrication of optical components in which passive alignment is achieved between device and fibre. Moreover, such devices can be constructed to provide a substantially planar surface for the resulting component, with consequent advantages in component fabrication and performance. Alignment is particularly effective, as the device and the fibre will respond equally to differences in the silicon V-groove dimension. If the groove is narrower than specified, the device and fibre will both be raised to substantially the same degree, and alignment will be preserved. A plurality of devices constructed in this fashion can be placed in a common groove, together with one or more fibres, so that all positioning of optical elements within the component can be conducted passively and with the same tolerance with respect to the V-groove formation. The formation of a substantially planar top surface, perhaps with additional circuitry deposited on or embedded in silicon adjacent to the V-groove, provides an environment in which extremely short connections can be made between different elements of the component, improving component performance and allowing a particularly compact design.

It will also be appreciated that the application of the present invention is not limited to the fabrication of optical components. The invention is particularly suitable for construction of components where precise alignment between two or more devices or other items is required - while this is most clearly necessary for optical components (and other components involving propagation of electromagnetic radiation), the skilled man will appreciate that where for other reasons precise alignment of components relative to each other is required, the combination of v-grooved "bench" and prismatic device is a particularly suitable one.

## Claims

1. Semiconductor device in the form of a prism having a top face and two side faces, wherein each side face makes with the top face a substantially equal acute angle in the device, wherein the parts of the device defining the two side faces comprise semiconductor material.

2. Semiconductor device as claimed in claim 1, wherein the edges of the semiconductor device between the top face and the two side faces are each pinned to a pinning edge of a layers overlying the semiconductor material defining that side faces.

3. A semiconductor device as claimed in claim 2, wherein the overlying layer for each side face comprises an edge mesa region not used as an active region within the device.

4. Semiconductor device as claimed in any preceding claim, wherein the semiconductor material defining the two side faces is InP.

5. Semiconductor device as claimed in any preceding claim, wherein the semiconductor device comprises an optical waveguide.

6. Semiconductor device as claimed in claim 5, wherein the semiconductor device is a semiconductor laser.

7. Semiconductor device as claimed in claim 6, wherein the semiconductor device is a buried heterostructure laser.

8. Semiconductor device as claimed in claim 6 or claim 7, wherein an active region of the semiconductor laser extends longitudinally along the semiconductor device and disposed centrally with regard to the two edge mesas.

9. Semiconductor component comprising a semiconductor substrate having a V-shaped groove therein and one or more semiconductor devices as claimed in any preceding claim located in the V-shaped groove, wherein the angle of the V-shaped groove is matched to the angle between the two side faces of the semiconductor device.

10. Semiconductor component as claimed in claim 9, wherein the semiconductor of the semiconductor substrate and the semiconductor defining the side faces of the semiconductor device have the same crystal structure, and wherein the side faces of the V-shaped groove and the side faces of the semiconductor device are defined by the same crystal plane of that crystal structure.

11. Semiconductor component as claimed in claim 9 or claim 10, wherein the semiconductor of the semiconductor substrate is silicon.

12. Semiconductor component as claimed in any of claims 9 to 11, wherein one or more waveguides are disposed in the V-shaped groove.

13. Semiconductor component as claimed in claim 12, wherein the one or more waveguides are optical fibres.

14. Semiconductor component as claimed in any of claims 9 to 13, wherein the V-shaped groove has an increased width region of shorter length than the semiconductor device, such that the semiconductor device is located to span the whole length of the increased width region.

15. Semiconductor component as claimed in claim 14, wherein the mounting surfaces of the V-groove for contact with the side faces of the semiconductor device are substantially smaller than the equivalent surfaces of the increased width region.

16. Method of manufacturing a semiconductor device, comprising:
depositing two edge mesas on a semiconductor substrate;
manufacturing a semiconductor device functionality between the two edge mesas;
etching back around the device functionality to reveal at least a part of each edge mesa;
etching the substrate using the edge mesas as masks to form angled side surfaces, the side surfaces each being disposed such as to make an acute angle within the substrate to a top surface of the substrate.

17. Method as claimed in claim 16, wherein the substrate consists of InP.

18. Method as claimed in claim 16 or 17, wherein the edge mesas comprise a ternary or a quaternary compound of indium.

19. Method as claimed in claim 17 or 18, wherein the top surface of the InP substrate defines a [100] plane, and the side surfaces of the substrate define [111] planes, wherein the etchant used in the step of etching the substrate to form the side surfaces is HBr.

20. Method as claimed in any of claims 16 to 19, further comprising the step of thinning the substrate after manufacture of the device functionality.

21. Method as claimed in any of claims 16 to 20, wherein an active region for the semiconductor device is formed in the same step as the formation of the edge mesa regions.

22. Method as claimed in claim 21, wherein the semiconductor device functionality is a semiconductor laser functionality.

23. Method as claimed in claim 22, wherein the semiconductor laser is a buried heterostructure, and wherein the manufacturing of a semiconductor device functionality comprises the steps of:
etching back to remove active region outside the edge mesas and the laser active region;
growing one or more blocking layers over the edge mesas and the device region except for the laser active region;
growing capping layers over the device region.

24. Method as claimed in claim 22, further comprising after the step of etching back around the device functionality:
growing a passivation layer over the device region and the edge mesas and patterning the passivation layer to provide a contact hole to the buried heterostructure laser;
metallising the device region to provide a metallic contact to the contact hole.

25. Method as claimed in any of claims 16 to 21, wherein the semiconductor device functionality comprises an optical waveguide.
